(19) **Europäisches Patentamt**

**European Patent Office**

**Office européen des brevets**

(11) Veröffentlichungsnummer : **0 385 134 B1**

(12) **EUROPÄISCHE PATENTSCHRIFT**

(45) Veröffentlichungstag der Patentschrift :
**07.09.94 Patentblatt 94/36**

(51) Int. Cl.$^5$ : **H03L 7/093, H04L 7/033**

(21) Anmeldenummer : **90102235.0**

(22) Anmeldetag : **05.02.90**

(54) **Verfahren zur Resynchronisation eines Taktes.**

(30) Priorität : **02.03.89 DE 3906689**

(43) Veröffentlichungstag der Anmeldung :
**05.09.90 Patentblatt 90/36**

(45) Bekanntmachung des Hinweises auf die
Patenterteilung :
**07.09.94 Patentblatt 94/36**

(84) Benannte Vertragsstaaten :
**AT BE CH DE ES FR GB GR IT LI NL SE**

(56) Entgegenhaltungen :
**US-A- 4 752 748**
**US-A- 4 827 225**
**PATENT ABSTRACTS OF JAPAN vol. 12, no.
393 (E-670)(3240) 19 Oktober 1988, & JP-A-63
135018 (NEC CORPORATION) 07 Juni 1988,**

(73) Patentinhaber : **SIEMENS
AKTIENGESELLSCHAFT
Wittelsbacherplatz 2
D-80333 München (DE)**

(72) Erfinder : **Ernst, Wolfram, Dipl.-Ing.
Karl-Witthalm-Strasse 9
D-8000 München 70 (DE)**

EP 0 385 134 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

**Beschreibung**

Die Erfindung betrifft ein Verfahren zur Resynchronisation eines Taktes, insbesondere Vermittlungstaktes einer Fernmeldevermittlungseinrichtung auf einen wiederkehrenden Referenztakt mit Hilfe eines Phasenregelkreises.

Bei der Synchronisation digitaler Fernmeldevermittlungseinrichtungen (z.B. Konzentratoren) ist es vielfach erforderlich, zur Minimierung des Roundtrip Delays die Synchronisation auf Basis ganzer PCM-Rahmen, d.h. mit 8 kHz durchzuführen. Der Roundtrip Delay ist dabei die Laufzeit eines Signals bei einem gesamten Umlauf von einem rufenden Teilnehmer zu dem gerufenen Teilnehmer und wieder zurück.

Außerdem werden bei derartigen Einrichtungen der untersten Netzebene spannungsgesteuerte Oszillatoren (VCO) geringer Eigenstabilität eingesetzt, so daß bei Ausfall der Synchronisation die Frequenz des Taktes relativ schnell wegdriften kann. Nach Wiederkehr des synchronisierenden Referenztaktes kann es deshalb gleichzeitig zu großen Frequenz- und Phasensprüngen am Eingang des Phasenregelkreises kommen.

Frequenzsprünge dürfen dabei den Phasendiskriminator des Phasenregelkreises nicht übersteuern, und Phasensprünge müssen stark gedämpft, d.h. ohne starke Veränderung der Frequenz des Taktes an die nachgeschalteten Abnehmer weitergegeben werden. Beides erfordert ein gegensätzliches Regelverhalten des Phasenregelkreises.

Der Erfindung liegt die Aufgabe zugrunde, die bei der Resynchronisation einer Vermittlungsstelle am Eingang des Phasenregelkreises auftretenden Phasensprünge langsam auszuregeln, Frequenzsprünge jedoch schnell.

Diese Aufgabe wird bei einem gattungsgemäßen Verfahren durch die kennzeichnenden Verfahrensschritte des Anspruchs 1 gelöst. Hierdurch wird erreicht, daß Phasensprünge mit einer kleinen Schleifenverstärkung, d.h. langsam ausgeregelt werden, während Frequenzsprünge mit einer großen Schleifenverstärkung, d.h. in kurzer Zeit ausgeregelt werden.

Nach einer Ausgestaltung der Erfindung wird der Schwellwert für die Frequenzdifferenz, der zur Unterscheidung zwischen Phasen- und Frequenzsprüngen dient, nach der beim Ausregeln eines Phasensprungs tolerierbaren Frequenzdifferenz festgelegt.

Nach einer weiteren Ausgestaltung der Erfindung wird das Überschreiten des Schwellwertes für die Frequenzdifferenz durch das Auftreten von Phasenkongruenz vor Ablauf einer bestimmten Prüfzeit festgestellt.

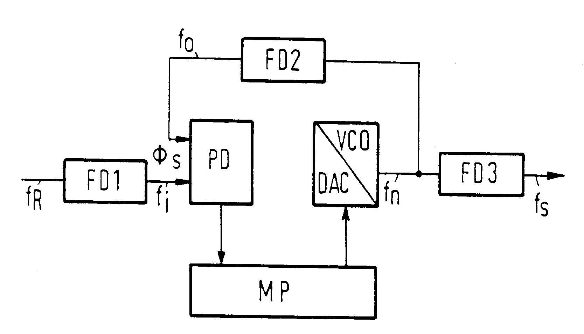

Ein Realisierungsbeispiel des erfindungsgemäßen Verfahrens mittels eines Mikroprozessors ist in der Zeichnung dargestellt und wird im folgenden näher erläutert.

Die Figur zeigt einen digitalen Phasenregelkreis, durch den ein Takt $f_S$ auf einen Referenztakt $f_R$ synchronisiert wird.

Der Phasenregelkreis beinhaltet einen Phasendiskriminator PD, einen Regler, der durch einen Mikroprozessor MP realisiert wird und der über einen Digital-Analog-Konverter DAC einen spannungsgesteuerten Oszillator VCO ansteuert, sowie eine Rückschleife, in der ein Ausgangstakt $f_n$ des spannungsgesteuerten Oszillators über einen zweiten Frequenzteiler FD2 herabgeteilt wird und als ein normierter Ausgangstakt $f_o$ auf den ersten Eingang des Phasendiskriminators zurückgeführt wird. An den zweiten Eingang des Phasendiskriminators liegt ein über einen ersten Frequenzteiler FD1 gebildeter normierter Referenztakt $f_i$ an. Der Takt $f_S$ entsteht über einen dritten Frequenzteiler FD3 aus dem Ausgangstakt $f_n$.

Ein bestimmter Frequenzsprung am Eingang des Phasendiskriminators bewirkt eine bestimmte maximale Phasendifferenz $\phi_{max}$ von der Größe $\phi_{max} = v/\alpha$, wobei $\alpha$ die Schleifenverstärkung des Phasenregelkreises und $v$ die normierte Frequenzdifferenz ($v = \Delta f/f$) zwischen dem Referenztakt $f_R$ und dem Takt $f_S$ aufgrund des Frequenzsprunges bedeutet. Um die maximale Phasendifferenz $\phi_{max}$ klein zu halten, muß also die Schleifenverstärkung $\alpha$ möglichst groß sein.

Ein Phasensprung $\phi_S$ am Eingang des Phasendiskriminators führt bei dessen Ausregelung zu einer maximalen Frequenzdifferenz $v_{max}$ von der Größe $v_{max} = \alpha\phi_S$. Um diesen Wert klein zu halten, muß also die Schleifenverstärkung $\alpha$ möglichst klein sein.

Diese gegensätzlichen Forderungen können mit Hilfe des Mikroprozessors wie folgt erfüllt werden. Nach wiederkehr der Referenzfrequenz $f_R$ verbleibt der Mikroprozessor MP maximal für eine Prüfzeit T weiterhin im Speicherbetrieb (hold over), d.h. der Mikroprozessor speichert die bei Ausfall der Synchronisation am Phasendiskriminator vorgelegene letzte korrekte Phasendifferenz bis maximal um die Prüfzeit T über die Ausfallzeit hinaus und hält den spannungsgesteuerten Oszillator VCO damit bis zum Start der Resynchronisation auf der entsprechenden Frequenz. Der Wert für die Prüfzeit T richtet sich nach einer beim Ausregeln eines Phasensprungs tolerierbaren Frequenzdifferenz $v_T$ zwischen dem Referenztakt $f_R$ und dem Takt $f_S$ und beträgt

$$T = l/(v_T \cdot f_o)$$

Die tolerierbare Frequenzdifferenz $v_T$ ist umso geringer, je weniger schnell der Phasenregelkreis Phasensprünge ausregeln soll, bzw. je stärker er Phasensprünge ausgangsseitig gegenüber den nachgeschalteten Abnehmern dämpfen soll.

Während der Prüfzeit T wird am Phasendiskriminator PD auf Phasenkongruenz zwischen den normierten Ausgangstakt $f_o$ und dem normierten Referenztakt $f_i$ geprüft. Tritt während der Prüfzeit T die erwähnte Phasenkongruenz am Phasendiskriminator PD auf, bedeutet dies, daß die Drift der Phasendifferenz (Frequenzdifferenz v) die bei Phasensprüngen tolerierbare Frequenzdifferenz $v_T$ überschreitet. Deshalb wird zu diesem Zeitpunkt die Resynchronisation mit einer großen Schleifenverstärkung gestartet, entsprechend der Ausregelung eines Frequenzsprunges. Die Phasendifferenz ist zu diesem Zeitpunkt gleich Null. Ein Restfehler entsprechend der Meß unschärfe ist tolerierbar. Später wird die Schleifenverstärkung dann stufenweise auf den Betriebswert erniedrigt.

Läuft die Prüfzeit T jedoch ab, ohne daß am Phasendiskriminator eine Phasenkongruenz zwischen dem normierten Ausgangstakt $f_o$ und dem normierten Referenztakt $f_i$ aufgetreten ist, so ist die Frequenzdifferenz v kleiner als die tolerierbare Frequenzdifferenz $v_T$ bei Ausregelung eines Phasensprungs. Die Resynchronisation wird deshalb mit kleiner Schleifenverstärkung gestartet, die dann stufenweise auf den Betriebswert erhöht wird.

## Patentansprüche

1. Verfahren zur Resynchronisation eines Taktes ($f_S$), insbesondere Vermittlungstaktes einer Fernmeldevermittlungseinrichtung auf einen wiederkehrenden Referenztakt ($f_R$) mit Hilfe eines Phasenregelkreises,
   **gekennzeichnet**
   durch folgende Merkmale:
   a) Nach der Wiederkehr des Referenztaktes ($f_R$) und vor dem Start der Resynchronisation wird geprüft, ob die am Eingang eines Phasendiskriminators (PD) des Phasenregelkreises auftretende Drift der Phasendifferenz zwischen dem Referenztakt ($f_R$) und dem Takt ($f_S$) einen bestimmten Schwellwert überschreitet,
   b) wird der Schwellwert überschritten, so wird die Resynchronisation mit einer großen Schleifenverstärkung gestartet,
   c) wird der Schwellwert unterschritten, so wird die Resynchronisation mit einer kleinen Schleifenverstärkung gestartet.

2. Verfahren nach Anspruch 1,
   **dadurch gekennzeichnet,**
   daß der Schwellwert nach der beim Ausregeln eines Phasenssprungs ($\phi_S$) tolerierbaren Frequenzdifferenz zwischen Referenztakt ($f_R$) und Takt ($f_S$) festgelegt wird.

3. Verfahren nach Anspruch 2,
   **dadurch gekennzeichnet,**
   daß das Überschreiten des Schwellwertes durch das Auftreten von Phasenkongruenz vor Ablauf einer bestimmten Prüfzeit festgestellt wird.

## Claims

1. Method for resynchronizing a clock ($f_S$), particularly switching clock of a telecommunications exchange, with a recurring reference clock ($f_R$) with the aid of a phase-locked loop, characterized by the following features:
   a) after the return of the reference clock ($f_R$) and before the start of the resynchronization, it is tested whether the drift, occurring at the input of a phase discriminator (PD) of the phase-locked loop, of the phase difference between the reference clock ($f_R$) and the clock ($f_S$) exceeds a specified threshold value,
   b) if the threshold value is exceeded, then the resynchronization is started with a large loop amplification,
   c) if the threshold value is not reached, then the resynchronization is started with a small loop amplification.

2. Method according to Claim 1, characterized in that the threshold value is defined according to the frequency difference between reference clock ($f_R$) and clock ($f_S$) that can be tolerated during correction of a phase shift ($\phi_S$).

3. Method according to Claim 2, characterized in that the exceeding of the threshold value as a result of the occurrence of phase congruence is determined before a specified testing time expires.

## Revendications

1. Procédé de resynchronisation d'une cadence ($f_S$), notamment d'une cadence de commutation d'une installation de commutation en télécommunications, sur une cadence ($f_R$) de référence, qui réapparaît, à l'aide d'une boucle à verrouillage de phase,
   remarquable par les caractéristiques suivantes :
   a) après que la cadence ($f_R$) de référence soit réapparue et avant que la resynchronisation n'ait commencé, on vérifie, si la dérive, apparaissant à l'entrée d'un discriminateur (PD) de phase de la boucle à verrouillage de phase, de la différence de phase entre la cadence ($f_R$) de référence et la cadence ($f_S$), dépasse une valeur de seuil prescrite,
   b) si la dérive de la différence de phase est supérieure à la valeur de seuil, on commence la resynchronisation avec un gain de boucle grand,
   c) si la dérive de la différence de phase est inférieure à la valeur de seuil, on commence la resynchronisation avec un gain de boucle petit.

2. Procédé suivant la revendication 1, caractérisé en ce que on fixe la valeur de seuil suivant la différence de fréquence entre la cadence ($f_R$) de référence et la cadence ($f_S$), qui peut être tolérée lors de la régulation d'un saut ($\Phi_S$) de phase.

3. Procédé suivant la revendication 2, caractérisé en ce que le dépassement de la valeur de seuil est fixé lorsqu'apparaît une congruence de phase avant qu'un temps de vérification déterminé ne soit écoulé.

EP 0 385 134 B1

5